# EUROPÄISCHE PATENTANMELDUNG

(11) **EP 1 710 095 A1**
(43) Veröffentlichungstag der Anmeldung: **11.10.2006**
(21) Anmeldenummer: 06007287.3
(22) Anmeldetag: 06.04.2006
(51) Int. Cl.: B41N 1/24, B41F 15/34, H05K 3/12, B41C 1/14

(54) **Verfahren zur Herstellung einer Druckschablone für den technischen Siebdruck**

(30) Priorität: 07.04.2005 DE 102005016027
(71) Anmelder: KOENEN GMBH, 85521 Ottobrunn (DE)
(72) Erfinder: Zimmermann, Günter, 85579 Neubiberg (DE); Moser, Karl-Heinz, 85649 Brunnthal (DE)
(74) Vertreter: Beetz & Partner

(57) **Zusammenfassung**

Die Erfindung betrifft ein Verfahren zur Herstellung einer Druckschablone für den technischen Siebdruck, bei welchem ein dünnwandiges hochfestes Rohblech (10) auf eine ebene Tragplatte (3) aufgespannt wird, in vorgegebenen Bereichen des Rohblechs Ausschnitte in genauer Positionierung mittels Laserstrahls ausgeschnitten werden sowie Schablonen in ihrer gewünschten Form aus dem Blechzuschnitt mittels Laserstrahls ausgeschnitten und ggf. an einer Oberfläche einer Feinbearbeitung unterzogen werden, wobei in ausgewählten Bereichen an mindestens einer Seite des eben aufgespannten Rohblechs (10) Einsenkungen (20, 21; 29, 30) durch Hochgeschwindigkeitsfräsen hergestellt werden.

## Beschreibung

Die Erfindung betrifft ein Verfahren zur Herstellung einer Druckschablone für den technischen Siebdruck, bei welchem ein dünnwandiges hochfestes Metallblech auf eine ebene Tragplatte aufgespannt wird, in vorgegebenen Bereichen dieses Metallblechs Ausschnitte (Pads) in genauer Positionierung mittels Laserstrahl ausgeschnitten werden, sowie Schablonen in ihrer gewünschten Form aus dem Blech mittels Laserstrahl ausgeschnitten und zumindest an einer Oberfläche einer Feinbearbeitung unterzogen werden.

Derartige Druckschablonen werden vorzugsweise in der sog. SMT-Technik (Surface Mounted Technology) verwendet, bei welcher Leiterplatten mit unterschiedlichen elektronischen Bauelementen bestückt und durch Lot elektrisch leitend befestigt werden. Dabei wird eine Lotpaste bzw. eine Kleberpaste mit Hilfe einer sog. Rakel auf die mit den genau positionierten Öffnungen versehene Schablone aufgestrichen. Die Ausschnitte oder Öffnungen in der Schablone bilden Löt- oder Klebepunkte, sog. Pads oder Lotpastendepots, in welchen die elektronischen Bauelemente durch einen automatisierten Bestückungsvorgang fixiert werden. Für den Lotpasten- bzw. Kleberdruck in der SMD-Leiterplattentechnik haben sich lasergeschnittene Metallschablonen in zwei verschiedenen Trägersystemen durchgesetzt. Bei Rahmenschablonen ist in einem rechteckigen formsteifen Rahmen aus Edelstahl- oder Al-Profilen in der Regel ein feinmaschiges Drucksieb eingespannt, in dessen zentralem Ausschnitt die eigentliche Schablone aus einem dünnwandigen Edelstahlblech mit Wandstärken von 40 bis 400 µm positioniert und z.B. durch Klebetechniken oder Schweißverbindungen mit ihrem umlaufenden Rand dauerhaft befestigt sind. Diese Rahmenschablonen zeichnen sich durch einfache Handhabung, hohe Stabilität und lange Standzeiten aus. Die daneben noch eingesetzten Lochrandschablonen bilden eine Ergänzung der Rahmenschablonen und zeichnen sich durch einen verringerten Platzbedarf sowie durch einen günstigeren Preis aus. Durch Kantenstabilisierung kann die Schablone verstärkt und ihre Handhabung vereinfacht werden. Zur exakten und dauerhaften Positionierung werden verschiedene Schnellspannsysteme eingesetzt.

Für mischbestückte Baugruppen mit komplexer Bestückungsvielfalt, wie z.B. "Pin in Paste", sind auch bereits sog. Stufenschablonen vorgeschlagen worden, bei denen das Schablonenmaterial vor dem Laserschneiden bearbeitet und an vordefinierten Stellen abgetragen wird. So entstehen in den Schablonen Stufen, die beim Drucken das Lotpastenvolumen bestimmen. Zur Herstellung derartiger Stufenschablonen werden Ätztechniken angewendet, um vorbestimmte Bereiche innerhalb der Schablone in einem vorgegebenen Maß abzutragen. Daneben wurden auch bereits Verdickungen in vorgegebenen Bereichen der Schablone durch galvanisches Abscheiden von Nickelschichten erzeugt. Schließlich ist aus der DE 100 43 471 ein Verfahren zur Herstellung einer Metallschablone bekannt, bei welchem in einer Metallfolie durchgehende Unterbrechungen in herkömmlicher Weise mittels Laserstrahls ausgeschnitten werden. In ausgewählte Durchbrechungen werden vorgefertigte Einsätze eingefügt und anschließend durch Laserschweißen mit der Metallfolie verbunden.

Alle bekannten Herstellungsverfahren von Schablonen mit wechselnder Wanddicke sind technisch außerordentlich aufwändig und mit hohen Kosten verbunden. Ferner sind die Standzeiten derartiger Schablonen begrenzt.

Die Nachteile eines extrem hohen Herstellungsaufwandes ergeben sich auch bei Anwendung anderer Formgebungsverfahren, beispielsweise dem Senkerodieren. Da die Tiefe der zu erodierenden Einsenkungen im Schablonenblech nur einen Teil der Blechdicke betragen darf, erfordern die notwendigen Senk-Genauigkeiten einen hohen maschinellen Aufwand. Daneben muss für jede Einsenkung im Schablonenblech eine gesonderte Elektrode gefertigt werden. Ferner treten hohe Wärmebelastungen in den funkenerosiv abzutragenden Bereichen auf, was regelmäßig zu Blaufärbungen des verwendeten Edelstahlblechs in diesen Bereichen führt. Auch andere einfache Abtragsverfahren, z.B. Schleifverfahren, haben sich als unbrauchbar erwiesen, da die jeweils bearbeiteten Bereiche hohen Wärmebelastungen ausgesetzt werden, was neben den unerwünschten Blaufärbungen zu thermischen Verzugserscheinungen führte.

Aufgabe der Erfindung ist es, ein Verfahren zur Herstellung von Druckschablonen für den technischen Siebdruck zu schaffen, mit dem auf technisch einfache Weise Schablonen mit unterschiedlichen Wandstärken, insbesondere mit relativ großflächigen Einsenkungen, kostengünstig und ohne nachteilige Wärmebeanspruchung hergestellt werden können.

Diese Aufgabe wird erfindungsgemäß dadurch gelöst, dass in ausgewählten Bereichen des eben aufgespannten Rohblechs Einsenkungen durch Hochgeschwindigkeitsfräsen hergestellt werden.

Die Herstellung von Einsenkungen im Schablonenblech durch HS-Fräsen ergab überraschenderweise keinerlei nachteilige Wärmebeanspruchungen des Schablonenmaterials bei ausreichend hohen Abtragsleistungen. Insbesondere treten weder Blaufärbungen des Edelstahls in den vorgegebenen abgetragenen Bereichen während oder nach dem Fräsvorgang noch thermische Verzugserscheinungen der verdünnten Blechbereiche auf. Eine technisch aufwändige Kühlung ist nicht erforderlich.

Um relativ großflächige Einsenkungen mit einer gleichbleibenden Tiefe von bis 60 % der Blechdicke herzustellen, wird ein vorzugsweise zwei- oder mehrschneidiger Stirnfräser, der in einen in den horizontalen Koordinatenachsen motorisch verfahrbaren Vertikal-Fräskopf eingespannt ist und mit Drehzahlen von bis zu 100.000 Upm angetrieben wird, in einem oder mehreren Fräsvorgängen in dem vorgewählten Bereich linear oder auf bogenförmigen Bahnen bewegt. Hinsichtlich der Wärmebelastung und der Spanbildung bzw. Spanabführung haben sich zweischneidige Stirnfräser von einigen Millimetern Durchmesser als besonders zweckmäßig erwiesen. Es wird davon ausgegangen, dass durch die hohen Drehzahlen und eine geeignete Schneidenanzahl sowie Schneidengeometrie durch die erzeugten Luftströme eine ausreichende Kühlwirkung erzielt wird.

Weiterhin ist es zweckmäßig, vor oder insbesondere nach dem Laserschneiden der Ausschnitte (Pads) die Oberfläche der gefrästen Einsenkungen feinzubearbeiten, beispielsweise durch Elektropolieren, wobei auch die restlichen Oberflächenbereiche der Schablone im gleichen oder einem nachfolgenden Vorgang feinbearbeitet werden können.

Obgleich es grundsätzlich möglich ist, die Ausschnitte im Schablonenblech vor dem Ausfräsen der eingesenkten Bereiche durch Lasern herzustellen, wird bevorzugt, diese Ausschnitte (Pads) in den eingesenkten Bereichen, d.h. nach dem jeweiligen Fräsvorgang herzustellen.

Um die gewünschte hohe Lagegenauigkeit von eingesenkten Bereichen und Ausschnitten im Schablonenblech zu gewährleisten, ist es zweckmäßig, die Einsenkungen und auch die Ausschnitte bzw. Pads in einer Aufspannung des jeweiligen Rohblechs herzustellen, was naturgemäß die Verwendung von zwei gesonderten Bearbeitungsaggregaten, nämlich eines Fräskopfs und eines Laserkopfs, verlangt.

Hochpräzise Einsenkungen können erfindungsgemäß auch durch Anwendung eines speziellen technisch anspruchsvollen Verfahrens hergestellt werden, das als Ultraschall-Abtragsverfahren bezeichnet wird und bei welchem ein in einen drehangetriebenen Kopf eingespanntes Spanwerkzeug zusätzlich in Ultraschall-Schwingungen versetzt wird.

Gegenstand der Erfindung ist auch ein Sieb für den technischen Siebdruck mit einem formsteifen Spannrahmen, einem am Spannrahmen unter Vorspannung dauerhaft befestigten feinmaschigen hochfesten Metallgewebe, mindestens einer in einem Ausschnitt des gespannten Metallgewebes allseitig befestigten Schablone aus einem dünnwandigen hochfesten Metallblech, in der Ausschnitte ausgebildet sind, wobei die Schablone in vorgewählten Bereichen ausgefräste Einsenkungen aufweist, deren wählbare Tiefe bis etwa 60 % der Blechdicke entspricht. Innerhalb und auch neben diesen Bereichen können die Ausschnitte ausgebildet sein.

Die Erfindung bietet gegenüber herkömmlichen Herstellungsverfahren verschiedene Vorteile. So ist die Tiefe der gefrästen Einsenkungen in vorgegebenen Grenzen frei wählbar, und zwar entweder durch feine Einstellung des Fräservorschubs oder durch Wiederholen der Fräsvorgänge. Ferner können die Einsenkungen nahezu beliebige Formen und Größen in ihrer Flächenerstreckung haben, da sie durch entsprechende Bewegungen des Fräsers in den horizontalen Koordinatenachsen erzeugt werden. Ein insbesondere bei Schablonenblechen aus Edelstahl besonderer Vorzug des erfindungsgemäßen Verfahrens ist die praktisch vernachlässigbare thermische Belastung der Blechbereiche während der Fräsbearbeitung, was auf die Anwendung des Hochgeschwindigkeitsfräsens sowie die Wahl der Schneidenanzahl des Stirnfräsers sowie der Spanwinkel zurückzuführen ist.

Im folgenden wird die Erfindung beispielhaft anhand der Zeichnung im einzelnen beschrieben. Es zeigen:
- Fig. 1: schematisch eine Vorrichtung zur Durchführung des erfindungsgemäßen Verfahrens;
- Fig. 2: ein Siebdruck-Sieb mit eingespannter Metallschablone.

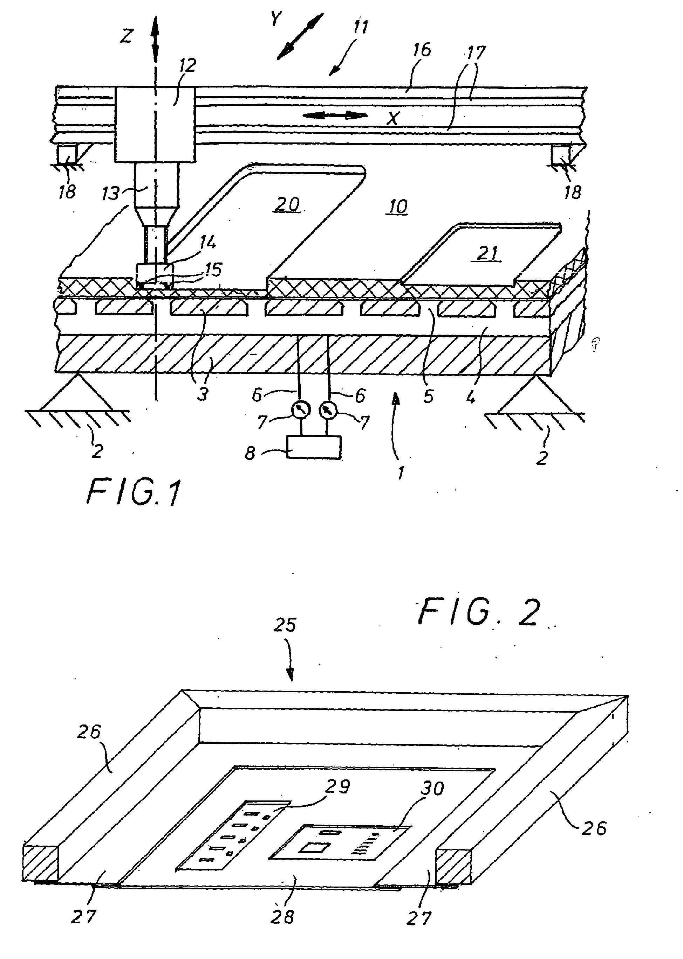

Die in Fig. 1 lediglich als Beispiel für eine mögliche Durchführung des erfindungsgemäßen Verfahrens in einem Ausschnitt dargestellte Vorrichtung enthält einen großflächigen Aufspanntisch 1, der auf einer - schematisch dargestellten - Rahmenkonstruktion 2 abgestützt ist. Die Trag- bzw. Auflageplatte 3 dieses Tisches 1 ist als sog. Vakuumplatte ausgebildet und weist eine durchgehende Unterdruckkammer 4 sowie eine Vielzahl von oberseitigen Öffnungen 5 auf. Zur Erzeugung eines Unterdruckes ist die Unterdruckkammer 4 über Zu- und Ableitungen 6 und Steuerorgane 7 an eine Unterdruckquelle 8 angeschlossen. Auf der Oberseite der Tragplatte liegt ein sog. Rohblech 10 aus Edelstahl auf, das eine Wanddicke von etwa 30 bis 400 µm haben kann. Die flächigen Abmessungen derartiger Rohbleche liegen je nach der Größe des Tisches 1 bei 400 x 800 mm. Durch Erzeugen eines Vakuums in der Unterdruckkammer 4 wird das Rohblech 10 über die Vielzahl von Saugöffnungen 5 an die Oberfläche der Tragplatte 3 verwerfungsfrei angesaugt.

Oberhalb des Tisches 1 ist eine Fräsvorrichtung 11 in Konsolbauweise angeordnet, die einen vertikalen Fräskopf 12 mit einem integrierten Hochgeschwindigkeitsantrieb enthält, der eine Arbeitsspindel 13 und einen in dieser eingespannten Stirnradfräser 14 aufweist. Bei der dargestellten Ausführung besitzt der Stirnradfräser 14 zwei Schneiden 15. Die verschiedenen Winkel und auch die Anzahl dieser Schneiden 15 können nach den jeweiligen Arbeitsbedingungen und dem Material des Rohblechs zur Erzielung einer korrekten Spanbildung und insbesondere einer vernachlässigbaren Erwärmung des Edelstahlblechs während des Fräsvorganges gewählt werden. Die Drehzahlen des Stirnradfräsers liegen im Hochgeschwindigkeitsbereich und betragen regelmäßig mehr als 20.000 Upm.

Der Fräskopf 12 ist an einer horizontalen Quertraverse 16 in zwei Führungsschienen 17 motorisch in der X-Koordinatenachse verfahrbar. Diese Quertraverse 16 wiederum ist endseitig auf zwei horizontalen Führungsschienen 18 abgestützt und auf diesen in Richtung der horizontalen Y-Koordinatenachse motorisch verfahrbar, so dass der Fräskopf 12 und mit diesem der Stirnfräser 15 gesteuerte Bewegungen in der horizontalen X-Y-Ebene ausführen kann.

Wie aus Fig. 1 ersichtlich, sind in dem Edelstahl-Rohblech 10 zwei Einsenkungen 20, 21 ausgefräst, deren jeweils unterschiedliche Tiefe durch Einstellung des Vorschubs der Arbeitsspindel 13 in der vertikalen Z-Koordinatenachse oder auch durch Wiederholen von flächigen Fräsvorgängen gewählt werden kann.

Zum Herstellen der Einsenkungen 20, 21 wird das Edelstahl-Rohblech 10 auf die Tragplatte 3 aufgelegt und durch Anlegen eines Unterdrucks fixiert. Anschließend werden in ausgewählten Bereichen die Einsenkungen 20, 21, die eine beliebige Form haben können, durch geeignete Verfahrbewegungen der Fräsvorrichtung 11 in der geeigneten Tiefe und Kontur gefräst.

Nach Herstellung der Einsenkungen 20, 21 in beliebiger Form und Anzahl wird das Rohblech 10 in gleicher oder gewendeter Ausrichtung auf einen weiteren Tisch ggf. mittels einer Vakuumtragplatte aufgespannt und in den vorgegebenen Bereichen des Rohblechs werden die geeigneten Ausschnitte in der gewünschten Anzahl und Form mit Hilfe eines Laserstrahls geschnitten. Zweckmäßigerweise ist die Lasereinheit in ähnlicher Weise wie die Fräsvorrichtung 11 ausgebildet.

Um die Einsenkungen 20, 21 und auch die Laserausschnitte im Rohblech in einer einzigen Aufspannung herstellen zu können, ist es zweckmäßig, eine Fräseinheit 11 und eine gesonderte Lasereinheit an der gleichen Tragkonstruktion jeweils an einem Ende anzuordnen, so dass in einem ersten Verfahrensgang die Einsenkungen gefräst und nach Verfahren der Fräsvorrichtung 11 in eine stirnseitige Stand-By-Position die Ausschnitte mittels der dann in ihrer Arbeitsstellung verfahrenen Lasereinheit geschnitten werden können. Durch diese Vorgehensweise kann ein vereinfachter Ablauf der Bearbeitungsvorgänge bei verbesserten Genauigkeiten und erhöhten Durchsatzleistungen erreicht werden.

Das in Fig. 2 schematisch dargestellte Drucksieb weist einen rechteckigen Rahmen 25 aus formsteifen Profilen 26 auf, an deren Unterseite ein feinmaschiges Siebgewebe 27 aus dünnen Edelstahldrähten z.B. durch Kleben oder Schweißen befestigt ist. In einem zentralen Ausschnitt dieses Edelstahlgewebes 27 befindet sich eine nach dem erfmdungsgemäßen Verfahren mit Einsenkungen versehene Metallschablone, die an ihrem umlaufenden Rand z.B. durch Rollschweißen mit dem Innenrand des Siebgewebes fest verbunden ist. In ausgewählten Bereichen dieser Schablone 28 sind zwei Einsenkungen 29, 30 ausgefräst, die durch Laserstrahlen erzeugte Ausschnitte aufweisen.

Das erfindungsgemäße Verfahren zur Herstellung der Einsenkungen in einem Rohblech kann auch auf anderen Vorrichtungen durchgeführt werden. So sind beispielsweise auch andere Befestigungs- bzw. Spanneinrichtungen für das Rohblech möglich, solange sichergestellt ist, dass das Rohblech ohne Verwerfungen großflächig auf der ebenen Oberseite einer Tischplatte aufliegt und gegen seitliches Verrutschen gesichert ist. Ferner sollte die jeweils eingesetzte Fräsvorrichtung 11 mit einer wirksamen Späneabsaugung kombiniert sein, damit sich die beim HS-Spanen auftretenden feinen Späne nicht in kritischen Zonen des Rohblechs und damit der zukünftigen Schablone ablagern können. Schließlich sollten durch geeignete Maßnahme auch elektrostatische Aufladungen des Rohblechs vermieden werden. Statt des bei dem dargestellten Ausführungsbeispiel verwendeten Rohblechs 10 aus Edelstahl können auch andere zur Herstellung von Druckschablonen geeignete Materialien und Werkstoffe verwendet und nach dem erfindungsgemäßen Verfahren bearbeitet werden.

Die durch die erfindungsgemäßen Abtragsverfahren hergestellten Einsenkungen können sich, je nach den Bedürfnissen der Anwender, an der Oberseite oder der Unterseite der fertigen Schablone befinden. Es ist auch möglich, Einsenkungen in beiden Seiten des Rohblechs auszubilden, die unterschiedliche Tiefen und Formen haben können. In diesem Fall werden die Einsenkungen an der einen Seite in der anhand der Fig. 1 dargestellten Weise hergestellt. Danach wird das Rohblech 10 gewendet und erneut auf der Tragplatte 3 fixiert, woraufhin die Einsenkungen an der anderen Blechseite in der vorstehend beschriebenen Weise ausgespant werden. Aufgrund der hohen erforderlichen Präzision verlaufen zumindest die Arbeitsvorgänge zur Herstellung der Einsenkungen und der Ausschnitte (Pads) programmgesteuert.

## Patentansprüche

1. Verfahren zur Herstellung einer Druckschablone für den technischen Siebdruck, bei welchem
- ein dünnwandiges hochfestes Rohblech (10) auf eine ebene Tragplatte (3) aufgespannt wird,
- in vorgegebenen Bereichen des Rohblechs Ausschnitte in genauer Positionierung mittels Laserstrahls ausgeschnitten werden sowie
- Schablonen in ihrer gewünschten Form aus dem Blechzuschnitt mittels Laserstrahls ausgeschnitten und ggf. an einer Oberfläche einer Feinbearbeitung unterzogen werden,
**dadurch gekennzeichnet, dass**
- in ausgewählten Bereichen an mindestens einer Seite des eben aufgespannten Rohblechs (10) Einsenkungen (20, 21; 29, 30) durch Hochgeschwindigkeitsfräsen hergestellt werden.

2. Verfahren nach Anspruch 1,
**dadurch gekennzeichnet, dass**
die Einsenkungen (20, 21; 29, 30) vor der Ausbildung der Ausschnitte mittels Laserstrahls mit einem zwei- oder mehrschneidigen Stirnfräser mit Drehzahlen von mehr als 25.000 Upm ungekühlt gefräst werden.

3. Verfahren nach Anspruch 1 oder 2,
**dadurch gekennzeichnet, dass**
die Einsenkungen (20, 21; 29, 30) durch horizontales Verfahren eines HS-Stirnradfräsers in beliebiger Form und Größe mit einer Tiefe bis zum 0,6-fachen der Blechdicke in einer oder mehreren Stufen gefräst werden.

4. Verfahren nach einem der vorstehenden Ansprüche,
**dadurch gekennzeichnet, dass**
die bei der Fräsbearbeitung anfallenden Partikel und Späne aus dem Arbeitsbereich z.B. durch Absaugen entfernt werden.

5. Verfahren nach einem der vorstehenden Ansprüche,
**dadurch gekennzeichnet, dass**
die Oberflächen zumindest der gefrästen Einsenkungen feinbearbeitet, z.B. poliert, werden.

6. Verfahren nach einem der vorstehenden Ansprüche,
**dadurch gekennzeichnet, dass**
die Einsenkungen (20, 21) und die Ausschnitte in einer Aufspannung des Rohblechs (10) hergestellt werden.

7. Verfahren nach einem der vorstehenden Ansprüche,
**dadurch gekennzeichnet, dass**
Einsenkungen in einem ersten Fräsvorgang an einer Seite und nach Wenden und erneutem Aufspannen des Rohblechs (10) in einem zweiten Fräsvorgang an der anderen Seite des Rohblechs (10) hergestellt werden.

8. Verfahren nach dem Oberbegriff des Anspruchs 1,
**dadurch gekennzeichnet, dass**
in ausgewählten Bereichen mindestens einer Seite des eben aufgespannten Rohblechs (10) Einsenkungen (20, 21; 29, 30) durch ungekühlte kombinierte Ultraschall- und spanende Bearbeitungsvorgänge hergestellt werden.

9. Sieb für den technischen Siebdruck, mit
- einem formsteifen Spannrahmen (25),
- einem am Spannrahmen unter Vorspannung dauerhaft befestigten feinmaschigen hochfesten Siebgewebe (27) und
- mindestens einer in mindestens einem Ausschnitt des gespannten Siebgewebes (27) allseitig befestigten Schablone (28) aus einem dünnwandigen hochfesten Metallblech, die in vorgegebenen Bereichen Ausschnitte aufweist,
**dadurch gekennzeichnet, dass**
- die Schablone (28) an zumindest einer Seite in vorgewählten Bereichen ausgefräste Einsenkungen (29) aufweist, deren wählbare Tiefe bis etwa 60 % der Blechdicke entspricht.
